# EUROPEAN PATENT SPECIFICATION

(11) **EP 3 370 315 B1**
(45) Date of publication and mention of the grant of the patent: **28.04.2021**
(21) Application number: 17158615.9
(22) Date of filing: 01.03.2017
(51) Int. Cl.: H02B 13/025

(54) **PRESSURE RELIEF DEVICE WITH SEALING MEANS**
DRUCKENTLASTUNGSVORRICHTUNG MIT DICHTUNGSMITTELN
DISPOSITIF DE LIBÉRATION DE PRESSION AVEC DES MOYENS D'ÉTANCHÉITÉ

(43) Date of publication of application: 05.09.2018
(73) Proprietor: ABB Schweiz AG, 5400 Baden (CH)
(72) Inventor: Nygren, Toni, 00380 Helsinki (FI); Kääpä, Matti, 00380 Helsinki (FI); Björkman, Niko, 00380 Helsinki (FI); Sääskilahti, Veli, 00380 Helsinki (FI)
(74) Representative: Kolster Oy Ab

(56) References cited:
- WO-A2-2012/067861
- JP-A- H0 340 701
- JP-A- S5 423 944
- JP-U- S59 145 207

## Description

### Field of the invention

The invention relates to a pressure release device and in particular to a pressure release device for an enclosure.

### Background of the invention

Electrical equipment, such as electrical power equipment and/or electronic equipment, which is placed e.g. outdoors may need to be protected from adverse conditions. Such protection can be accomplished with a suitable enclosure around the electrical equipment. An example of an enclosure for electrical equipment is an indoor or outdoor cabinet made of plastics and/or metals which can be used to protect the contents from the environment and also to prevent electrical shock to equipment users, for example.

Such enclosures for electrical equipment, for instance, may be provided with a pressure release device, such as an explosion vent, an explosion hatch or a rupture panel, in order to relieve an excess pressure difference between the interior and the exterior of the enclosure and to avoid further damage to the enclosure and the surroundings thereof, for example. Such an excess pressure difference between the interior and the exterior of the enclosure could result from an electrical short circuit arc or fire, for example, within the enclosure which may cause a rapid pressure increase inside the enclosure.

Such pressure release devices may have various requirements for its operation. For example, the pressure release device should be able to relieve the excess pressure fast enough and possibly also to a certain predetermined direction in order to avoid or minimize the consequences. Moreover, enclosures for electrical equipment, for instance, may be designed to be at least partly sealed from the outside of the enclosure in order to protect the inside of the enclosure and the contents thereof from dust, dirt and moisture, for example, or generally to make the enclosure weatherproof. Pressure release devices possibly used in such enclosures, for example, may be required to be able to provide at least the same level of sealing as the enclosure itself. In addition, pressure release devices used in enclosures for electrical equipment, for instance, may further have requirements for its EMC (Electromagnetic Compatibility) characteristics.

Examples of pressure release devices are disclosed in JP S54-23944 A, JP H03-40701 A, and JP S59-145207 U.

" A problem related to such pressure release devices is that they are often relatively expensive to manufacture due to their complex structure and/or relatively expensive to maintain if, after an operation thereof, the pressure release device, or a part of it, needs to be replaced, for example.

### Brief description of the invention

An object of the invention is to develop equipment so as to solve or at least to alleviate the above-mentioned problem or at least to provide an alternative solution. The object of the invention is achieved by a pressure release device as defined the independent claim 1. Preferred embodiments of the invention are disclosed in the dependent claims.

The invention is based on the idea of a pressure release device comprising at least one pressure release arrangement having a base part provided with a group of openings therethrough, and a cover part comprising a group of protrusions which in a closed position of the cover part are configured to extend inside into the openings of the group of openings such that the openings are closed by the protrusions in a sealed manner. In an open position of the cover part the protrusions are configured to be removed from the openings.

The invention provides the advantage that the pressure release device can be realized with a simple structure, which enables lower manufacturing and maintenance costs.

### List of figures

The invention will now be described in more detail in connection with preferred embodiments and with reference to the accompanying drawings, in which:
Figure 1 shows a pressure release device according to an embodiment;
Figure 2 shows a pressure release device according to an embodiment;
Figure 3 shows a pressure release device according to an embodiment;
Figure 4 shows a pressure release device according to an embodiment;
Figure 5 shows an example of a group of protrusions according to an embodiment;
Figure 6 shows a sectional view of a pressure release arrangement according to an embodiment;
Figure 7 shows a sectional view of a pressure release device according to an embodiment; and
Figure 8 shows an enclosure according to an embodiment.

### Detailed description of the invention

According to the invention, a pressure release device has a first side and a second side. According to the invention, the pressure release device comprises at least one pressure release arrangement comprising a base part provided with a group of openings therethrough, and a cover part comprising a group of protrusions corresponding to the group of openings of the base part. According to the invention, in a closed position of the cover part each protrusion of said group of protrusions is configured to extend inside into a corresponding opening of the group of openings and to close the opening in a sealed manner. According to an embodiment, in an open position of the cover part the protrusions of said group of protrusions are configured to be removed from the openings of the group of openings. According to an embodiment, the cover part is configured to move from its closed position into its open position in response to a pressure in the second side of the pressure release device exceeding a pressure in the first side of the pressure release device at least by a predetermined threshold.

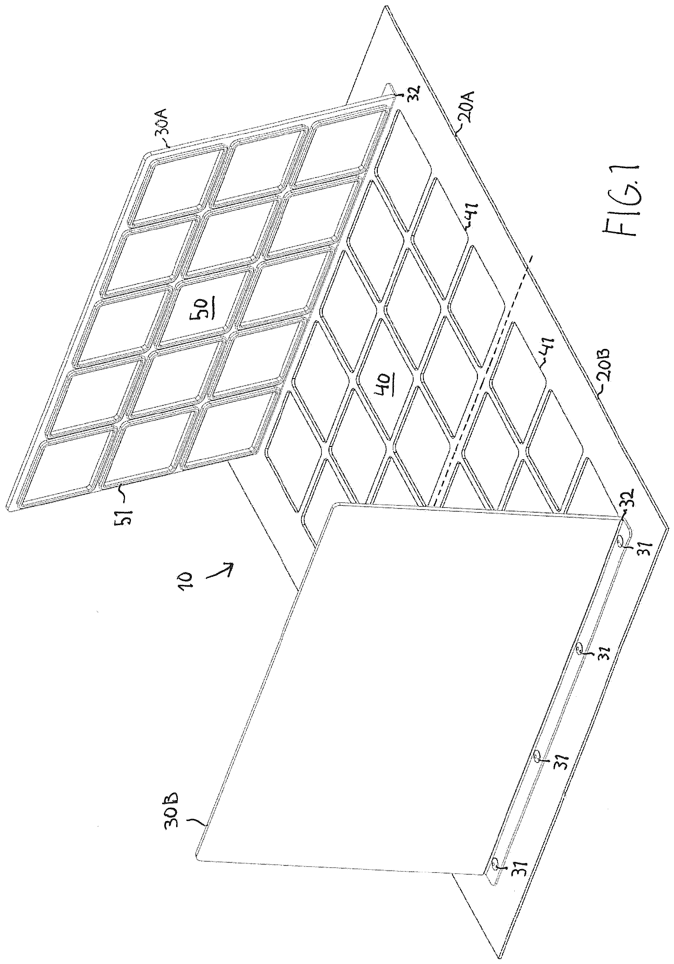

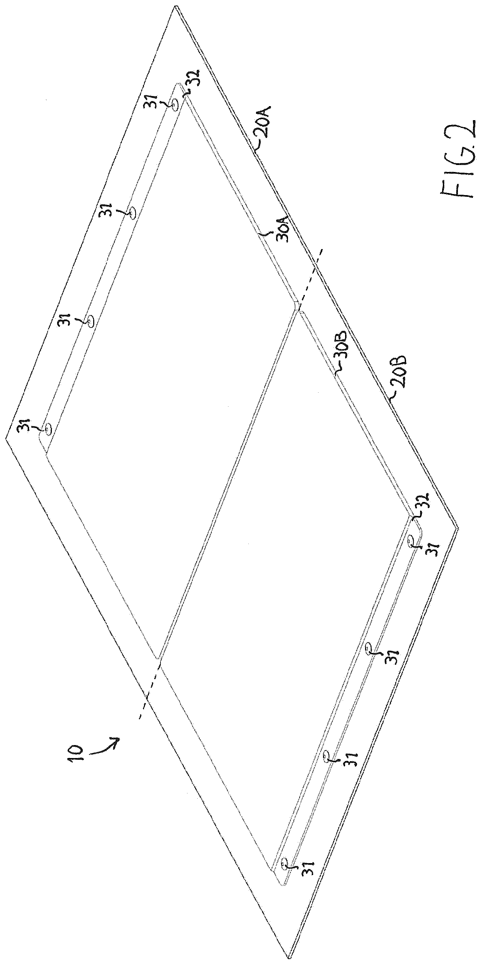

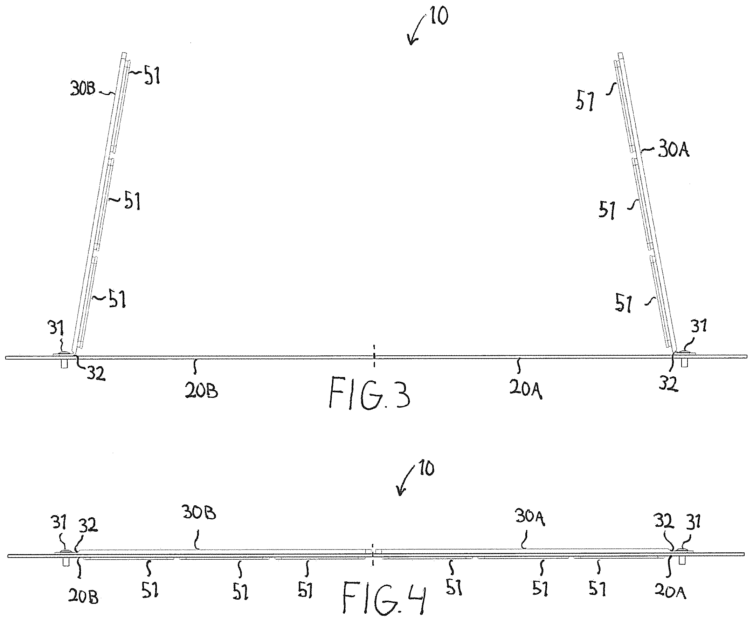

Figure 1 shows a pressure release device 10 according to an exemplary embodiment. Moreover, Figure 3 shows the exemplary pressure release device 10 corresponding to that of Figure 1 in another view. In the example of Figure 1, the first side of the pressure release device 10 is facing up and the second side of the pressure release device 10 is facing down. In the example of Figure 1, the pressure release device 10 comprises two pressure release arrangements; the first one with a base part 20A and a corresponding cover part 30A, and the second one with a base part 20B and a corresponding cover part 30B. The base parts 20A, 20B of both exemplary pressure release arrangements are provided with a group 40 of 3 x 5 openings 41. The cover parts 30A, 30B of both exemplary pressure release arrangements comprise a group 50 of 3 x 5 protrusions 51 corresponding to the group of openings of the respective base part. Thus, in both pressure release arrangements the number and order of the openings 41 of the group of openings 40 corresponds to the number and order of the protrusions 51 of the group of protrusions 50. In the example of Figure 1 the exemplary pressure release device 10 is shown with the cover parts 30A, 30B in their open positions. As shown in the figure, in an open position of the cover part 30A, 30B the protrusions 51 of the group of protrusions 50 are removed from the openings 41 of the respective group of openings 40. Hence, in the open position of the cover part 30A, 30B the openings 41 of the base part 20A, 20B are unobstructed and provide a pathway between the first side and the second side of the pressure release device 10 via which a pressure difference between the first side and the second side can be released. Figure 2 shows the exemplary pressure release device 10 corresponding to that of Figure 1 with the cover parts 30A, 30B in their closed positions. Moreover, Figure 4 shows the exemplary pressure release device 10 corresponding to that of Figure 2 in another view. As shown in the figures, in the closed position of the cover part 30A, 30B each protrusion 51 of said group of protrusions 50 extends inside into a corresponding opening 41 of the group of openings 40, such that the opening is closed by the protrusion in a sealed manner. The protrusions 50 may partly extend through the corresponding openings 40, as can be seen in Figure 4. The level of the sealing may vary and may be liquid resistant or liquid tight sealing and/or gas tight sealing, for example. According to an embodiment, said at least one pressure release arrangement is configured to be at least liquid resistant when the cover part 30A, 30B thereof is in its closed position. When the cover part 30A, 30B is in its closed position, it will move from the closed position into its open position when the pressure in (against) the second side of the pressure release device 10 exceeds the pressure in (against) the first side of the pressure release device at least by a predetermined threshold which corresponds to a force required to move the cover part 30A, 30B from its closed position into its open position. The force required to move the cover part 30A, 30B from its closed position into its open position depends on how tightly the protrusions 51 of the cover part 30A, 30B fit into the respective openings 41 of the base part 20A, 20B. Hence, the predetermined threshold can be adjusted by adjusting the fitting between the protrusions and their respective openings 41, for example. The cover part 30A, 30B can be reclosed after the opening thereof without the need to change any part of the pressure release arrangement as a result of the operation thereof.

According to an embodiment, the cover part 30A, 30B of the pressure release arrangement is fastened to the base part 20A, 20B of the pressure release arrangement in a hinged manner. Such fastening may be implemented from one edge of the cover part 30A, 30B, as shown in the exemplary figures, or from one corner of the cover part 30A, 30B, for example, by using suitable fastening means 31, such as screws, rivets and/or adhesives. A hinge portion 32 can be formed integrally in the cover part 30A, 30B by using flexible material in the construction of the cover part. Moreover, the cover part 30A, 30B may be thinned at such a hinge portion 32 in order to make it more flexible, if necessary.

According to an embodiment, the openings 41 of the group of openings 40 of the base part are rectangular, polygonal, circular and/or oval in shape, for example. Generally the shape of the openings 41 can vary and openings 41 of one group of openings 40 can be of the same shape or at least some of them can be of different shape than others. Also the size of the openings 41 can vary and openings 41 of one group of openings 40 can be of the same size or at least some of them can be of different size than others. The number of openings 41 in one group of openings 40 can also vary but is preferably at least two. When the number of openings 41 in a group of openings 40 is increased, the support provided by the base part 20A, 20B for the cover part 30A, 30B against sagging or sinking of the cover part 30A, 30B can be increased as the structure or grid formed by the portions of the base part 20A, 20B between the openings 41 thereof becomes denser. Hence, even if the total area of openings 41 in a group of openings 40 is kept constant, increasing the number of openings 41 while decreasing their size makes the grid formed by the portions of the base part 20A, 20B between the openings 41 denser and potentially provides a better covering support for the cover part.

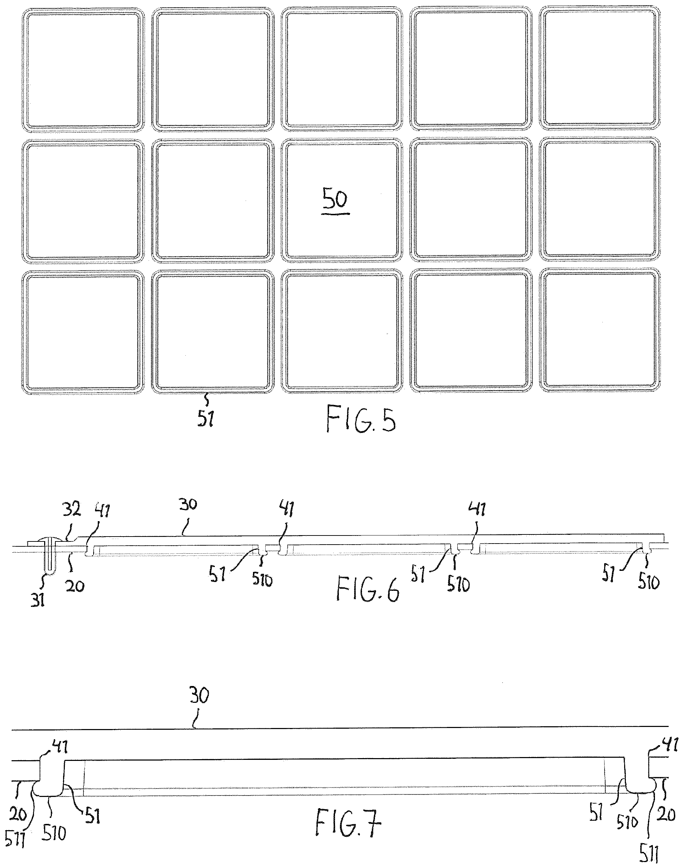

The protrusions 51 of a group of protrusions 50 may have a generally same shape and size as the counterpart openings 41 of the corresponding group of openings 40 so that the protrusions are be able to close the openings in a sealed manner. Figure 5 shows an example of a group of protrusions 50 comprising 3 x 5 protrusions 51 and corresponding to the exemplary embodiment shown in Figures 1 to 4. According to an embodiment, at least a portion of each of the protrusions 51 of the group of protrusions 50 of the cover part is made of flexible material. Such flexible material can comprise rubber, plastic, or a combination thereof, for example. Figure 6 shows a sectional view of a pressure release arrangement according to an embodiment comprising a base part 20 and a cover part 30 which may correspond to the base parts 20A, 20B and over parts 30A, 30B shown in the exemplary embodiments of Figures 1 to 4, for example. Figure 7 shows a close-up view of such a sectional view of the pressure release arrangement according to an embodiment. According to an embodiment, head portions 510 of the protrusions 51 of the group of protrusions of the cover part 30 are configured to extend through the openings 41 of the group of openings of the base part 20 in the closed position of the cover part 30. As can be seen in the example of Figure 6, the head portions (tips) 510 of the protrusions 51 of the cover part 30 can extend through the openings 41 of the base part 20 into the second side of the base part 20 (i.e. lower side in the figure) from the first side of the base part 20 (i.e. upper side in the figure) where the main portion of the cover part 30 is located in. Moreover, according to an embodiment, the head portions 510 of the protrusions 51 of the group of protrusions of the cover part 30 comprise a lip portion 511 which in the closed position of the cover part 30 is configured to extend outside of a perimeter of the respective opening 41. In the more detailed view of Figure 7 showing detail of one protrusion 51 and one opening 41 it can be seen how the head portion 510 of the protrusion 51 has a lip portion 511 which extends (in the figure to the left and to the right) outside of the perimeter of the opening 41. The size and shape of such a lip portion 511 can vary and differ from the one shown in the figures. When at least a portion of the protrusions 51 of the cover part is made of flexible material, a cover part 30 with protrusions 51 having such lip portions 511 can be closed and opened because of the flexibility of the protrusion. In the closed position of the cover part 30, as shown in Figures 6 and 7, such a lip portion 511 extending outside of the perimeter of the respective opening 41 can be used to provide a better sealing of the opening 41 by the protrusion 51 and/or to provide a better fastening of the cover part 30 in its closed position. In addition, the force required to move the cover part 30 from its closed position into its open position, and hence the predetermined threshold, could be adjusted by adjusting the shape and/or size of such lip portions 511 of the protrusions 51, for example.

According to an embodiment, the cover part 30, 30A, 30B according to the various embodiments above may comprise a generally sheet-like body from one side of which the protrusions 51 extend. Hence, the cover part 30, 30A, 30B can essentially constitute a hatch comprising the group protrusions 50. The area covered by such a sheet-like body is preferably at least as large as the area covered by the group of openings to be covered by the cover part. More preferably, the area covered by such a sheet-like body is larger than the area covered by the group of openings to be covered by the cover part in order to provide better sealing of the openings by the cover part also near the edges of the cover part. According to an embodiment, the cover part 30, 30A, 30B according to the various embodiments above could be made entirely of flexible material comprising rubber, plastic, or a combination thereof, for example. The cover part 30, 30A, 30B could be manufactured as a single integral unit. Possible manufacturing methods of the cover part 30, 30A, 30B include injection moulding and compression moulding but other methods are possible as well.

According to an embodiment, the base part 20, 20A, 20B according to the various embodiments above is made of rigid material. According to an embodiment, such a rigid material comprises metal and/or plastic, for example. Material comprising metal may be preferable if the pressure release device needs to comply with certain predetermined EMC requirements, for example. According to an embodiment the base part 20, 20A, 20B can comprise a sheet portion provided with said group of openings 40 therethrough. In the examples of Figures 1 to 4 and 6 to 7, the base part 20, 20A, 20B is essentially comprised of such a sheet portion only. However, the base part 20, 20A, 20B could additionally comprise additional parts or different structure not shown in these examples, for example.

According to an embodiment, the pressure release device 10 can comprise only one pressure release arrangement or two or more pressure release arrangements. In case the pressure release device comprises at least two pressure release arrangements, the base parts 20A, 20B of at least two pressure release arrangements can be integrally formed with each other. In the examples of Figures 1 to 4 the two base parts 20A, 20B of the two pressure release arrangements are integrally formed as a single piece. It is also possible to integrally form base parts of two or more pressure release arrangements by connecting them together or attaching them to each other in a suitable manner depending on e.g. the material of the base parts of the pressure release arrangements in question. If the pressure release device 10 comprises at least two pressure release arrangements, the opening directions of the cover parts 30A, 30B of the pressure release arrangements can vary from the examples shown, for example.

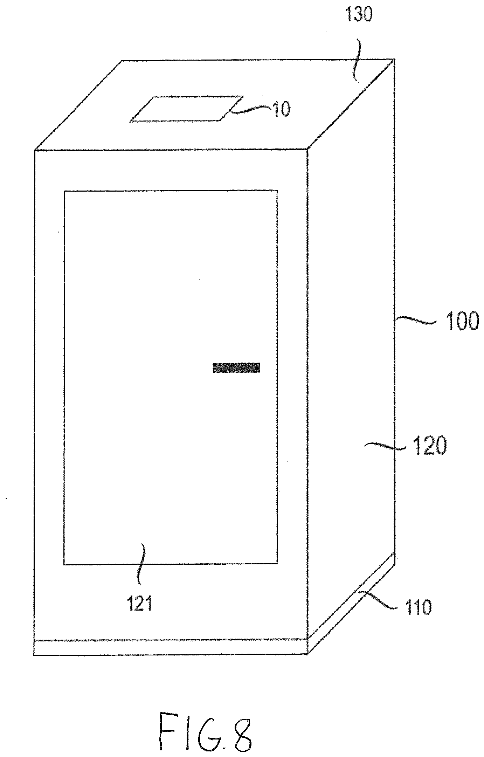

According to an embodiment, an enclosure for electrical equipment comprises at least one pressure release device as described in any of the embodiments above. Figure 8 shows an enclosure 100 according to an embodiment. It should be noted that the shape and size of the enclosure 100 may vary. The enclosure may be used for housing electrical equipment, such as electrical power equipment and/or electronic equipment or other electrical equipment, for example. The exemplary enclosure 100 comprises a bottom part 110, a wall part 120 and a roof part 130, which define an interior chamber for housing the electrical equipment. The wall part 120 may comprise one or more wall elements, for example four wall elements as in Figure 8. The enclosure 100 may comprise at least one door 121 providing access to the interior of the enclosure. The bottom part 110, the wall part 120 and the roof part 130 may be made of metal, such as sheet metal, or plastic materials, for example. The exemplary enclosure 100 further comprises at least one pressure release device 10 mounted in an opening in the enclosure 100. In the example of Figure 8 the opening for the pressure release device 10 is located in the roof part 130 but could be located in the wall part 120 or in the door 121 instead, for example. The pressure release device 10 may be mounted in the enclosure 100 by using suitable fastening means, such as screws, rivets and/or adhesives, in a removable or fixed manner.

A person skilled in the art will find it obvious that, as technology advances, the basic idea of the invention may be implemented in many different ways. The invention and its embodiments are thus not restricted to the examples described above but may vary within the scope of the claims.

## Claims

1. A pressure release device having a first side and a second side, the pressure release device (10) comprising at least one pressure release arrangement comprising:
a base part (20; 20A, 20B) provided with a group of openings (40) therethrough; and
a cover part (30; 30A, 30B) comprising a group of protrusions (50) corresponding to the group of openings (40) of the base part, wherein in a closed position of the cover part each protrusion (51) of said group of protrusions is configured to extend inside into a corresponding opening (41) of the group of openings and to close the opening in a sealed manner, and in an open position of the cover part the protrusions (51) of said group of protrusions are configured to be removed from the openings (41) of the group of openings, and wherein the cover part (30; 30A, 30B) is configured to move from the closed position into the open position in response to a pressure in the second side of the pressure release device (10) exceeding a pressure in the first side of the pressure release device at least by a predetermined threshold,
wherein at least a portion of each of the protrusions (51) of the group of protrusions (50) of the cover part (30; 30A, 30B) is made of flexible material, **characterized in that** head portions (510) of the protrusions (51) of the group of protrusions (50) of the cover part (30; 30A, 30B) of the pressure release arrangement are configured to extend through the openings (41) of the group of openings (40) of the base part (20; 20A, 20B) of the pressure release arrangement in the closed position of the cover part and comprise a lip portion (511) which in said closed position of the cover part is configured to extend outside of a perimeter of the respective opening (41).

2. A pressure release device as claimed in claim 1, wherein the cover part (30; 30A, 30B) of the pressure release arrangement is fastened to the base part (20; 20A, 20B) of the pressure release arrangement in a hinged manner.

3. A pressure release device as claimed in claim 1 or 2, wherein the openings (41) of the group of openings (40) of the base part (20; 20A, 20B) are rectangular, polygonal, circular and/or oval in shape.

4. A pressure release device as claimed in claim 1, 2 or 3, wherein the flexible material comprises rubber, plastic, or a combination thereof.

5. A pressure release device as claimed in any one of claims 1 to 4, wherein the base part (20; 20A, 20B) is made of rigid material.

6. A pressure release device as claimed in claim 5, wherein the rigid material comprises metal and/or plastic.

7. A pressure release device as claimed in any one of claims 1 to 6, wherein the base part (20; 20A, 20B) comprises a sheet portion provided with said group of openings (40) therethrough.

8. A pressure release device as claimed in any one of claims 1 to 7, wherein said at least one pressure release arrangement is configured to be at least liquid resistant when the cover part (30; 30A, 30B) thereof is in its closed position.

9. A pressure release device as claimed in any one of claims 1 to 8, comprising at least two pressure release arrangements.

10. A pressure release device as claimed in claim 9, wherein the base parts (20A, 20B) of at least two pressure release arrangements are integrally formed with each other.

11. An enclosure for electrical equipment comprising at least one pressure release device (10) as claimed in any one of claims 1 to 10.

## Patentansprüche

1. Druckentlastungsvorrichtung mit einer ersten Seite und einer zweiten Seite, wobei die Druckentlastungsvorrichtung (10) mindestens eine Druckentlastungsanordnung aufweist, umfassend:
ein Basisteil (20; 20A, 20B), das mit einer Gruppe von Öffnungen (40) versehen ist; und
ein Deckelteil (30; 30A, 30B), umfassend eine Gruppe von Vorsprüngen (50), die der Gruppe von Öffnungen (40) des Basisteils entsprechen, wobei in einer geschlossenen Stellung des Deckelteils jeder Vorsprung (51) der Gruppe von Vorsprüngen dazu ausgelegt ist, sich nach innen in eine entsprechende Öffnung (41) der Gruppe von Öffnungen zu erstrecken und die Öffnung in einer abgedichteten Weise zu schließen, und in einer geöffneten Stellung des Deckelteils die Vorsprünge (51) der Gruppe von Vorsprüngen dazu ausgelegt sind, von den Öffnungen (41) der Gruppe von Öffnungen entfernt zu sein, und wobei das Deckelteil (30; 30A, 30B) dazu ausgelegt ist, sich in Reaktion auf einen Druck in der zweiten Seite der Druckentlastungsvorrichtung (10), der einen Druck in der ersten Seite der Druckentlastungsvorrichtung mindestens um einen vorbestimmten Schwellenwert überschreitet, aus der geschlossenen Stellung in die geöffnete Stellung zu bewegen,
wobei mindestens ein Abschnitt jedes der Vorsprünge (51) der Gruppe von Vorsprüngen (50) des Deckelteils (30; 30A, 30B) aus flexiblem Material hergestellt ist,
**dadurch gekennzeichnet, dass**
Kopfabschnitte (510) der Vorsprünge (51) der Gruppe von Vorsprüngen (50) des Deckelteils (30; 30A, 30B) der Druckentlastungsanordnung dazu ausgelegt sind, sich in der geschlossenen Stellung des Deckelteils durch die Öffnungen (41) der Gruppe von Öffnungen (40) des Basisteils (20; 20A, 20B) der Druckentlastungsanordnung zu erstrecken, und einen Lippenabschnitt (511) umfassen, der in der geschlossenen Stellung des Deckelteils dazu ausgelegt ist, sich außerhalb eines Umfangs der jeweiligen Öffnung (41) zu erstrecken.

2. Druckentlastungsvorrichtung gemäß Anspruch 1, wobei das Deckelteil (30; 30A, 30B) der Druckentlastungsanordnung an dem Basisteil (20; 20A, 20B) der Druckentlastungsanordnung scharnierartig befestigt ist.

3. Druckentlastungsvorrichtung gemäß Anspruch 1 oder 2, wobei die Öffnungen (41) der Gruppe von Öffnungen (40) des Basisteils (20; 20A, 20B) eine rechteckige, mehreckige, kreisförmige und/oder ovale Form aufweisen.

4. Druckentlastungsvorrichtung gemäß Anspruch 1, 2 oder 3, wobei das flexible Material Gummi, Kunststoff oder eine Kombination davon umfasst.

5. Druckentlastungsvorrichtung gemäß einem der Ansprüche 1 bis 4, wobei das Basisteil (20; 20A, 20B) aus einem starren Material hergestellt ist.

6. Druckentlastungsvorrichtung gemäß Anspruch 5, wobei das starre Material Metall und/oder Kunststoff umfasst.

7. Druckentlastungsvorrichtung gemäß einem der Ansprüche 1 bis 6, wobei das Basisteil (20; 20A, 20B) einen Plattenabschnitt umfasst, der mit der Gruppe von Öffnungen (40) durch diesen hindurch versehen ist.

8. Druckentlastungsvorrichtung gemäß einem der Ansprüche 1 bis 7, wobei die mindestens eine Druckentlastungsanordnung dazu ausgelegt ist, mindestens flüssigkeitsfest zu sein, wenn sich ihr Deckelteil (30; 30A, 30B) in seiner geschlossenen Stellung befindet.

9. Druckentlastungsvorrichtung gemäß einem der Ansprüche 1 bis 8, umfassend mindestens zwei Druckentlastungsanordnungen.

10. Druckentlastungsvorrichtung gemäß Anspruch 9, wobei die Basisteile (20A, 20B) von mindestens zwei Druckentlastungsanordnungen einstückig miteinander ausgebildet sind.

11. Gehäuse für eine elektrische Ausrüstung, umfassend mindestens eine Druckentlastungsvorrichtung (10) gemäß einem der Ansprüche 1 bis 10.

## Revendications

1. Dispositif de décharge de pression présentant un premier côté et un deuxième côté, le dispositif (10) de décharge de pression comprenant au moins un agencement de décharge de pression comprenant :
une pièce socle (20 ; 20A, 20B) pourvue d'un groupe d'ouvertures (40) la traversant ; et
une pièce couvercle (30 ; 30A, 30B) comprenant un groupe de protubérances (50) correspondant au groupe d'ouvertures (40) de la pièce socle ; dans une position fermée de la pièce couvercle, chaque protubérance (51) dudit groupe de protubérances étant configurée pour s'étendre à l'intérieur jusque dans une ouverture (41) correspondante du groupe d'ouvertures et pour fermer l'ouverture de façon hermétique et, dans une position ouverte de la pièce couvercle, les protubérances (51) dudit groupe de protubérances étant configurées pour être retirées des ouvertures (41) du groupe d'ouvertures ; et la pièce couvercle (30 ; 30A, 30B) étant configurée pour passer de la position fermée à la position ouverte dès lors qu'une pression dans le deuxième côté du dispositif (10) de décharge de pression dépasse au moins d'un seuil prédéterminé une pression dans le premier côté du dispositif de décharge de pression,
au moins une partie de chacune des protubérances (51) du groupe de protubérances (50) de la pièce couvercle (30 ; 30A, 30B) étant constituée d'un matériau souple,
**caractérisé en ce que** des parties têtes (510) des protubérances (51) du groupe de protubérances (50) de la pièce couvercle (30 ; 30A, 30B) de l'agencement de décharge de pression sont configurées pour s'étendre au travers des ouvertures (41) du groupe d'ouvertures (40) de la pièce socle (20 ; 20A, 20B) de l'agencement de décharge de pression dans la position fermée de la pièce couvercle et comprennent une partie lèvre (511) qui, dans ladite position fermée de la pièce couvercle, est configurée pour s'étendre à l'extérieur d'un périmètre de l'ouverture (41) respective.

2. Dispositif de décharge de pression selon la revendication 1, dans lequel la pièce couvercle (30 ; 30A, 30B) de l'agencement de décharge de pression est attachée à la pièce socle (20 ; 20A, 20B) de l'agencement de décharge de pression de manière articulée.

3. Dispositif de décharge de pression selon la revendication 1 ou 2, dans lequel les ouvertures (41) du groupe d'ouvertures (40) de la pièce socle (20 ; 20A, 20B) sont de forme rectangulaire, polygonale, circulaire et/ou ovale.

4. Dispositif de décharge de pression selon la revendication 1, 2 ou 3, dans lequel le matériau souple comprend un caoutchouc, un plastique ou une combinaison des deux.

5. Dispositif de décharge de pression selon l'une quelconque des revendications 1 à 4, dans lequel la pièce socle (20 ; 20A, 20B) est constituée d'un matériau rigide.

6. Dispositif de décharge de pression selon la revendication 5, dans lequel le matériau rigide comprend un métal et/ou un plastique.

7. Dispositif de décharge de pression selon l'une quelconque des revendications 1 à 6, dans lequel la pièce socle (20 ; 20A, 20B) comprend une partie feuille pourvue dudit groupe d'ouvertures (40) la traversant.

8. Dispositif de décharge de pression selon l'une quelconque des revendications 1 à 7, dans lequel ledit au moins un agencement de décharge de pression est configuré pour être au moins résistant aux liquides lorsque sa pièce couvercle (30 ; 30A, 30B) occupe sa position fermée.

9. Dispositif de décharge de pression selon l'une quelconque des revendications 1 à 8, comprenant au moins deux agencements de décharge de pression.

10. Dispositif de décharge de pression selon la revendication 9, dans lequel les pièces socles (20A, 20B) d'au moins deux agencements de décharge de pression sont formées en un seul tenant.

11. Enceinte pour équipement électrique comprenant au moins un dispositif (10) de décharge de pression selon l'une quelconque des revendications 1 à 10.
